**Europäisches Patentamt**

**European Patent Office**

**Office européen des brevets**

(19)

(11)  **EP 0 821 770 B1**

(12)  **EUROPÄISCHE PATENTSCHRIFT**

(45) Veröffentlichungstag und Bekanntmachung des Hinweises auf die Patenterteilung:
**28.02.2001   Patentblatt 2001/09**

(21) Anmeldenummer: **96913435.2**

(22) Anmeldetag: **19.04.1996**

(51) Int Cl.[7]: **F16C 33/12**, F16C 33/14

(86) Internationale Anmeldenummer:
**PCT/DE96/00729**

(87) Internationale Veröffentlichungsnummer:
**WO 96/33352 (24.10.1996 Gazette 1996/47)**

(54)  **KONKAV GEKRÜMMTES GLEITELEMENT UND VERFAHREN ZU SEINER HERSTELLUNG**

CONCAVE SLIDING ELEMENT AND PRODUCTION PROCESS THEREFOR

ELEMENT DE GLISSEMENT A COURBURE CONCAVE ET SON PROCEDE DE PRODUCTION

(84) Benannte Vertragsstaaten:
**AT BE CH DE ES FR GB IT LI PT SE**

(30) Priorität: **21.04.1995  DE 19514835**

(43) Veröffentlichungstag der Anmeldung:
**04.02.1998   Patentblatt 1998/06**

(73) Patentinhaber: **Federal-Mogul Wiesbaden GmbH
65201 Wiesbaden (DE)**

(72) Erfinder:
 • **STEEG, Michael
   D-55270 Ober-Olm (DE)**
 • **GOEDICKE, Klaus
   D-01307 Dresden (DE)**
 • **KOPTE, Torsten
   D-01157 Dresden (DE)**
 • **METZNER, Christoph
   D-01324 Dresden (DE)**

(74) Vertreter: **Fuchs Mehler Weiss & Fritzsche
Patentanwälte
Postfach 46 60
65036 Wiesbaden (DE)**

(56) Entgegenhaltungen:
**EP-A- 0 452 647      AT-B- 392 291
DE-A- 2 853 724      DE-A- 2 914 618
DE-A- 2 935 417      DE-A- 2 940 376
DE-A- 3 606 529      DE-A- 3 729 414
US-A- 4 946 747**

**Beschreibung**

Die Erfindung betrifft ein Verfahren zur Herstellung von gleitflächenseitig konkav gekrümmten Gleitelementen, bei denen auf einen Trägerkörper insbesondere im Vakuum ein Schichtsystem mit mindestens einer Gleitschicht aus einer metallischen Dispersionslegierung aufgebracht wird. Solche Gleitelemente, auch Radialgleitlager genannt, haben z.B. als hochbelastete Lager bzw. Lagerschalen in Verbrennungskraftmaschinen Bedeutung erlangt.

Bei Radialgleitlagern tritt im allgemeinen die höchste Beanspruchung, d.h. abrasive Belastung, im Scheitelbereich der Lagerschalen auf. In der Nähe der Teilflächen, das sind die vom Scheitel entfernt liegenden Bereiche, sind dagegen verschleißartige und dynamische Belastungen wesentlich geringer. Durch mechanische Vorarbeit mit Einfluß auf die geometrische Gestaltung, z.B. Abweichung von der Kreisbogenform, wird u. a. versucht, die Ausbildung eines optimalen Schmierfilms und das Einbettungsverhalten für Fremdteilchen zu gewährleisten.

Entstehen beim Aufbringen des Schichtsystems Dickenunterschiede zwischen dem Scheitelbereich und dem Bereich der Teilflächen, so weicht die Gleitfläche von der idealen Kreisform ab. Durch mechanische Vorbearbeitung des Trägerkörpers kann dafür ein Ausgleich geschaffen werden. Diese Maßnahme erschwert und verteuert jedoch die Vorbearbeitung erheblich.

Lagerschalen mit gleichmäßigem Wanddicken-Verlauf können auch für V-Motoren und Motoren mit schräggeteilten Pleuelstangen eingesetzt werden. Dort liegt die Hauptlastzone außerhalb des Scheitelbereiches.

Es ist bekannt, bei hochbelastbaren Gleitelementen die Gleitschichten durch Vakuumbeschichtung aufzubringen. So ist es bekannt, eine Gleitschicht auf der Basis Al-Sn-Cu durch Zerstäuben (Sputtern) aufzubringen (DE 28 53 724 C3, DE 29 40 376 A1, DE 37 29 414 A1).

Es ist auch bekannt, Schichten mit eingelagerten Kunststoffteilchen aufzustäuben (DE 29 14 618 C2).

Weiterhin ist eine speziell der Beschichtungsgeometrie von Lagerschalen angepaßte Zerstäubungsvorrichtung bzw. eine Vorrichtung zur Aufnahme von Trägerkörpern für die Herstellung von Gleitlagern durch Zerstäuben bekannt. Allgemein können durch die vorgenannten Materialien, die durch Zerstäuben im Vakuum aufgebracht werden, hochbelastbare Gleitschichten hergestellt werden (AT 392 291 B, EP 0 452 647 A1). Zerstäuben ist jedoch aufgrund seines Wirkmechanismus ein teures Verfahren, weil sich die Abscheiderate nicht über eine bestimmte Grenze hinaus erhöhen läßt. Daher sind diesem Verfahren enge Grenzen gesetzt. Das Zerstäuben hat andererseits den Vorteil, daß eine gleichmäßige Beschichtung auch auf gebogenen Teilen wie Gleitlagern möglich ist.

Es ist auch bekannt, Gleitlager aus bandförmigen Halbzeugen herzustellen, bei welchen durch Vakuumbedampfung eine Gleitschicht auf das Band aufgebracht wird (DE 36 06 529 C2, DE 29 35 417). Ziel dieser bekannten Verfahren war die kostengünstigere Herstellung von Gleitlagern. Die DE 36 06 529 C2 beschreibt ein Verfahren zur Herstellung von Schichtwerkstoff, bei dem mittels Elektronenstrahlbedampfung die Gleitschicht auf Bandmaterial aufgebracht wird. Die aufgebrachte Gleitschicht besteht aus einer metallischen Dispersionslegierung. Das Aufdampfen erfolgt mit Beschichtungsraten von ungefähr 0,3 µm/s. Versuche, ein derart beschichtetes Band zu einem Gleitlager weiterzuverarbeiten, führten jedoch nicht zu einem brauchbaren Ergebnis, weil der hohe Verformungsgrad zu Beschädigungen oder Brüchen innerhalb des Schichtverbundes führte.

Der Erfindung liegt die Aufgabe zugrunde, ein Verfahren bereitzustellen, mit dem die Schichten eines hochbelastbaren Gleitelements bzw. Gleitlagers so ausgebildet werden können, daß diese bei allen betriebsbedingten Belastungen die an sie gestellten Anforderungen erfüllen, wobei das Verfahren hochproduktiv und umweltfreundlich sein soll, d.h. galvanische Verfahren zumindest teilweise ablösen soll.

Erfindungsgemäß wird die Aufgabe mit einem Verfahren gelöst, bei dem auf einen Trägerkörper ein Schichtsystem, das mindestens eine Schicht aus einer metallischen Dispersionslegierung aufweist, die mindestens in einem Winkelbereich von ± 70°, bezogen auf den Scheitelbereich des Trägerkörpers, eine Abweichung der Schichtdicke von weniger als 15%, bezogen auf die Maximalschichtdicke, aufweist, aufgebracht wird, wobei

- nach einer Vorbehandlung des konkav gekrümmten Trägerkörpers mindestens eine Schicht, vorzugsweise die Gleitschicht, durch Elektronenstrahlbedampfüng derart aufgebracht wird, daß vom Verdampfer bis zur Ebene des Scheitelbereiches des Gleitelementes ein Abstand von 150 bis 350 mm eingestellt wird,

- Verdampfer und Trägerkörper relativ zueinander ein dimensional mit ungleichförmiger Geschwindigkeit bewegt werden, die beim Ein- und Austritt in bzw. aus der Dampfwolke größer ist als über dem Zentrum der gebildeten Dampfkeule,

- der Trägerkörper rechtwinklig zu seiner Achsenrichtung bewegt wird,

- Teile des Dampfstromes durch mindestens eine Blende, die relativ zum Verdampfer feststeht und vorzugsweise im Zentrum des Dampfstromes angeordnet ist, ausgeblendet werden, und

- die Kondensationsrate für die Abscheidung der Schicht im Scheitelbereich des Trägerskörpers auf mindestens 80 nm/sec eingestellt wird.

Weitere vorteilhafte Ausgestaltungen des Verfahrens zeigen die Patentansprüche 2 bis 15.

Es wird nach einer an sich bekannten Vorbehandlung auf den Trägerkörper mindestens die Gleitschicht durch Elektronenstrahlbedampfung aus einem Verdampfer aufgebracht. Das Verfahren ist dadurch gekennzeichnet, daß die Schichtabscheidung unter streng definierten geometrischen Beschichtungsbedingungen und mit vorgegebener Abscheidegeschwindigkeit durchgeführt wird. Es hat sich gezeigt, daß durch diese Verfahrensmerkmale die Ausbildung einer Gleitschicht mit optimaler Schichtstruktur und eine Matrix mit extrem feinverteilten dispersen Komponenten erreicht wird. Im Gegensatz zu den nach den bekannten Verfahren hergestellten Gleitschichten zeigen diese eine hohe Tragfähigkeit und gute tribologische Eigenschaften. Neben der Abscheidegeschwindigkeit bestimmt auch der Einfallswinkel beim Bedampfen maßgeblich die Ausbildung der Mikrostruktur besagter Gleitschicht und damit ihre Eigenschaften.

Durch die Erfindung wird erreicht, daß bei Formteilen, wie Gleitlagerschalen, eine einfache Vorbearbeitung beibehalten wird und ein kostengünstiges hochproduktives Schichtabscheidungsverfahren genutzt werden kann, dessen Einsatz bisher weder die erforderliche Schichtgleichmäßigkeit noch ausreichende Schichteigenschaften erbrachte. Überraschenderweise kann festgestellt werden, daß erfindungsgemäß hergestellte Gleitelemente die Eigenschaften und Wirtschaftlichkeit von solchen, die nach dem bisherigen Stand der Technik hergestellt sind, übertreffen. Insbesondere weisen derartige Schichten gegenüber galvanisch aufgebrachten Schichten eine wesentlich höhere Dauerfestigkeit auf. So haben Versuche gezeigt, daß die Gebrauchsdauer im Hinblick auf vorgegebene Belastungen wesentlich verbesser wird, wenn die Gleitschicht durch Elektronenstrahlbedampfung erzeugt wird. Hierfür sind folgende Ursachen ausschlaggebend.

Durch die energetischen Verhältnisse beim Bedampfen mit hoher Abscheiderate wird eine extreme Feinverteilung der dispers eingelagerten Komponenten in die Matrix der Dispersionslegierung erreicht. Die dabei entstehende Struktur der Schicht gewährleistet eine sehr hohe, mit zunehmender Schichtdicke steigende Tragfähigkeit. Die hohe Gleichmäßigkeit der Schichtdicke auf einem großen Bereich des Umfanges ($\pm 70°$) der Lagerschale in Kombination mit der durch Elektronenstrahlbedampfung erreichbaren Schicht- und Gefügestruktur gewährleistet eine hohe Qualität der Gleitelemente. Sie bestimmt in maßgeblichem Grad die Ausbildung des Schmierfilms und das Einbettvermögen für Fremdpartikel und Abrieb.

Vorzugsweise wird mindestens auf der dem Dampfstrom zugewandten Seite der Blende eine Temperatur oberhalb des Schmelzpunktes des Verdampfungsmaterials eingestellt. Dadurch wird verhindert, daß der Dampf auf der Blende kondensiert.

Für das Gleitelement haben sich insbesondere metallische Dispersionslegierungen, enthaltend mindestens ein Metall aus der Gruppe Al, Pb, Cd, Sn, Zn, Ni und Cu, bewährt. Vorzugsweise weist die Dispersionslegierung 15 bis 35 Gew.-% Sn und 0,1 bis 3,0 Gew.-% Cu und Al auf.

Vorzugsweise werden die Komponenten der Dispersionslegierung überwiegend in ihrer metallischen Form und nur zu einem Bruchteil als oxydische, nitridische oder carbidische Verbindungen aufgebracht.

Das erfindungsgemäße Verfahren hat weiterhin den Vorteil, daß die Dispersionslegierung für die Gleitschicht aus einem Verdampfer aufgedampft werden kann, wobei es aber auch möglich ist, mindestens zwei Komponenten der Dispersionslegierung aus einzelnen eng nebeneinander angeordneten Verdampfertiegeln aufzudampfen.

Besonders vorteilhaft hat sich erwiesen, Gleitelemente wie Radialgleitlager mit einer Diffusionssperrschicht zwischen Trägerkörper und Gleitschicht auszustatten und diese ebenfalls durch Elektronenstrahlbedampfung aufzubringen. Deren Schichtdicke variiert in einem Winkelbereich von $\pm 70°$, bezogen auf den Scheitel, um weniger als 15 %.

Vorzugsweise besteht die Diffusionssperrschicht aus Nickel, Nickel/Zinn, Nickel/Kupfer, Nickel/Chrom, Titan oder Titannitrid. Die Diffusionssperrschicht kann auch durch Zerstäuben aufgebracht werden.

Das Verfahren zum Aufdampfen der Gleitschicht und/oder der Diffusionssperrschicht kann im Vakuum ohne Reaktivgas oder reaktiv unter Zufuhr eines Reaktionsgases und/oder plasmaaktiviert ausgeführt werden. Das Verfahren wird im wesentlichen durch die Auswahl des aufzudampfenden Materials bestimmt. Als Reaktivgas werden vorzugsweise Sauerstoff, Stickstoff oder Kohlenwasserstoffverbindungen oder ein Gemisch dieser Gase verwendet.

Anhand eines Ausführungsbeispieles wird die Erfindung näher erläutert. Es zeigen:

Fig. 1 eine perspektivische Darstellung einer Lagerschale,

Fig. 2 eine schematische Darstellung einer Verdampfereinrichtung für Lagerschalen.

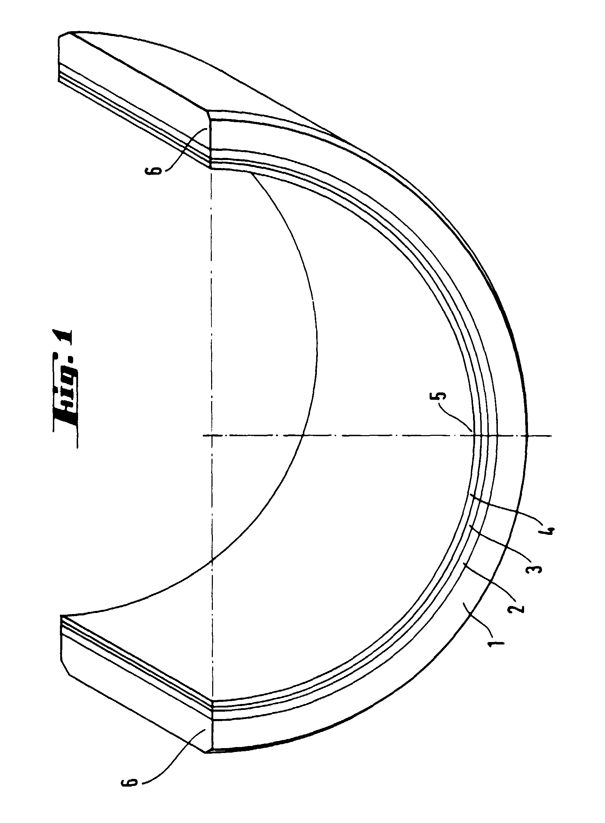

Die Fig. 1 zeigt eine Lagerschale, bestehend aus einem Trägerkörper 1 aus Stahl, auf dem eine Zwischenschicht 2 aus Bleibronze, eine Diffusionssperrschicht 3 aus Nickel-Chrom sowie eine Gleitschicht 4 aus Aluminium-Zinn-Kupfer aufgebracht ist. Sie bilden ein Schichtsystem. Der Verlauf bzw. das Dickenverhältnis des Schichtsystems, im wesentlichen der Diffusionssperrschicht 3 und der Gleitschicht 4, ist derart ausgebildet, daß in dem Winkelbereich von $\pm 70°$, bezogen auf den scheitelbereich 5, eine Abweichung der Schichtdik-

ke von weniger als 15 %, bezogen auf die Maximalschichtdicke, die im Scheitelbereich 5 auftritt, erreicht wird. Der Trägerkörper 1 und die Zwischenschicht weisen ebenfalls eine kontinuierliche Dicke auf. Die Teilflächen 6 bilden den Rand der Lagerschale.

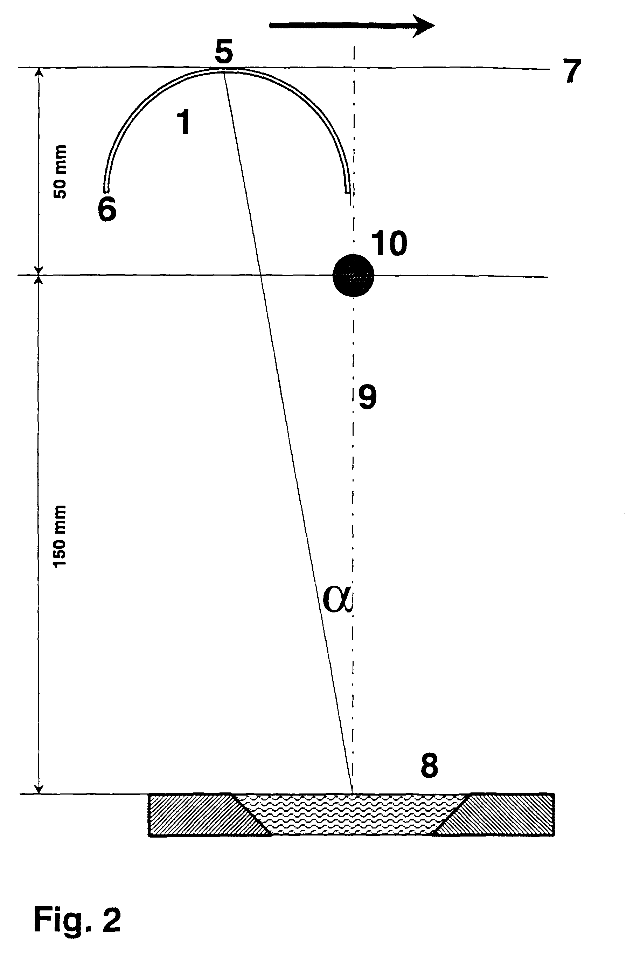

Die Fig. 2 dient zur Erläuterung des Verfahrens zur Herstellung von Lagerschalen. Das Verfahren wird wie folgt ausgeführt.

Auf den Trägerkörper 1 sind in bekannter Weise die Zwischenschicht 2 aus Bleibronze und die Diffusionssperrschicht 3 aus Nickel galvanisch oder aus Nikkel-Chrom gesputtert aufgebracht. Danach wird der beschichtete Trägerkörper 1 entfettet und gereinigt.

In eine Vakuumverdampfungsanlage werden die so vorbehandelten Trägerkörper 1 eingebracht und nach deren Evakuierung auf einen Druck von 0,01 Pa durch einen Sputterätzprozeß gereinigt. Der Trägerkörper 1 ist zunächst durch eine bedienbare Blende (nicht dargestellt) vor Bedampfung geschützt.

Mindestens ein Trägerkörper 1 wird auf einer Ebene parallel zur Verdampferbadoberfläche über den Verdampfer 8 in Pfeilrichtung bewegt. Der Trägerkörper 1 ist dabei so angeordnet, daß seine Achsenrichtung rechtwinklig zur Bewegungsrichtung liegt. Die Geschwindigkeit der linearen Bewegung wird dabei so gesteuert, daß sie beim Ein- und Austritt in bzw. aus der Dampfwolke größer ist als über dem Zentrum der gebildeten Dampfkeule. Der Geschwindigkeitsverlauf $v(\alpha)$ ist kontinuierlich und folgt nach der Beziehung:

$$v(\alpha) = v_{max} - v_o \cdot \cos(2\alpha)$$

$\alpha$ ist der Winkel zwischen der Normalen 9 auf dem Zentrum des Verdampfers 8 und dem Scheitelbereich 5. Der günstige Bereich für den Winkel $\alpha$ liegt dabei zwischen -45° und +45 °.

$V_{max}$ ist die Maximalgeschwindigkeit beim Ein- und Austritt in bzw. aus der Dampfkeule. Ihre Größe liegt etwa bei 1 m/min.

$v_o$ ist eine Normierungsgröße. Sie liegt im Bereich von 0,5 bis 0,7 m/min.

Der Abstand zwischen dem Verdampfertiegel 8 und der Ebene 7 des Scheitelbereiches 5 des Trägerkörpers 1 wird auf 200 mm eingestellt. Der Verdampfertiegel 8 ist zum Aufbringen der Gleitschicht mit Material der Legierung AlSn20Cu0.25 gefüllt. Er wird durch den Elektronenstrahl einer axialen Elektronenkanone (nicht dargestellt) beheizt. Es wird ein bekanntes Verdampfungsverfahren angewendet, das die weitgehende Übereinstimmung der Zusammensetzung von Verdampfungs- und Schichtmaterial sichert. Die Bedampfungsrate in der Ebene 7 des Scheitelbereiches 5 des Trägerkörpers 1 wird auf 300 nm/s eingestellt.

Zwischen dem Verdampfertiegel 8 und der Ebene 7 des Scheitelbereiches 5 ist in einer Höhe von 150 mm über der Oberfläche des Verdampfertiegels 8 zentral ein 15 mm dicker elektrisch beheizter Stab 10 angeordnet. Der beheizte Stab 10 wirkt als Dampfblende und hat eine Oberflächentemperatur oberhalb der Schmelztemperatur des Verdampfungsgutes. Auf diese Weise wird eine nennenswerte Kondensation von Dampf auf dem Stab 10 verhindert.

Durch Öffnen der Blende und die Bewegung des Trägerkörpers 1 in die Bedampfungszone ($\alpha = -45°$) wird die Bedampfung eingeleitet. Beim Erreichen der Bedampfungszone wird der Trägerkörper 1 nach dem beschriebenen Geschwindigkeitsverlauf über den Verdampfertiegel 8 hinwegbewegt. Nach einer Zeit von 80 Sekunden wird die Blende geschlossen und die Bedampfung abgebrochen. Durch die genannte Einstellung der Beschichtungsparameter wird bei Trägerkörpern 1 mit einem Krümmungsradius von 25 mm eine Schichtdicke von 18±1 µm im Scheitelbereich 5 und von 17 ± 1 µm im Bereich der Teilflächen 6 erreicht.

Die Schichtdickenverteilung entspricht damit der genannten Bedingung. Die unter den angegebenen Bedingungen durch Elektronenstrahlbedampfung abgeschiedene Gleitschicht 4 erfüllt höchste Qualitätsanforderungen.

Zur Erhöhung der Produktivität des Verfahrens werden in bekannter Weise Linienverdampfer eingesetzt und über diesen gleichzeitig mehrere Gleitelemente in Achsenrichtung nebeneinander angeordnet.

**Patentansprüche**

1.   Verfahren zur Herstellung von konkav gekrümmten Gleitelementen, bei dem auf einen Trägerkörper (1) ein Schichtsystem, das mindestens eine Schicht aus einer metallischen Dispersionslegierung aufweist, die mindestens in einem Winkelbereich von ± 70°, bezogen auf den Scheitelbereich (5) des Trägerkörpers (1), eine Abweichung der Schichtdicke von weniger als 15%, bezogen auf die Maximalschichtdicke, aufweist, aufgebracht wird, wobei

- nach einer Vorbehandlung des konkav gekrümmten Trägerkörpers (1) mindestens eine Schicht (4) durch Elektronenstrahlbedampfung derart aufgebracht wird, daß vom Verdampfer (8) bis zur Ebene des Scheitelbereiches (5) des Gleitelementes ein Abstand von 150 bis 350 mm eingestellt wird,

- Verdampfer (8) und Trägerkörper (1) relativ zueinander ein dimensional mit ungleichförmiger Geschwindigkeit bewegt werden, die beim Ein- und Austritt in bzw. aus der Dampfwolke größer ist als über dem Zentrum der gebildeten Dampfkeule,

- der Trägerkörper (1) rechtwinklig zu seiner Achsenrichtung bewegt wird,

- Teile des Dampfstromes durch mindestens eine Blende (10), die relativ zum Verdampfer (10) feststeht und vorzugsweise im Zentrum des Dampfstromes angeordnet ist, ausgeblendet werden, und

- die Kondensationsrate für die Abscheidung der Schicht im Scheitelbereich des Trägerskörpers (1) auf mindestens 80 nm/sec eingestellt wird.

2. Verfahren nach Anspruch 1, **dadurch gekennzeichnet,** daß mindestens auf der dem Dampfstrom zugewandten Seite der Blende (10) eine Temperatur oberhalb des Schmelzpunktes des Verdampfungsmaterials eingestellt wird.

3. Verfahren nach einem der Ansprüche 1 oder 2, **dadurch gekennzeichnet,** daß die mindestens eine Schicht eine Gleitschicht aus einer metallische Dispersionslegierung ist.

4. Verfahren nach Anspruch 3, **dadurch gekennzeichnet,** daß die Dispersionslegierung der aufgedampften Gleitschicht mindestens ein Metall aus der Gruppe Aluminium, Blei, Cadmium, Zinn, Zink, Nickel, Kupfer enthält.

5. Verfahren nach einem der Ansprüche 3 oder 4, **dadurch gekennzeichnet,** daß die Dispersionslegierung der aufgedampften Gleitschicht aus 15 bis 35 Gew.-% Zinn und 0,1 bis 3 Gew.-% Kupfer und Aluminium besteht.

6. Verfahren nach einem der Ansprüche 3 bis 5, **dadurch gekennzeichnet,** daß die Komponenten der Dispersionslegierung überwiegend in ihrer metallischen Form und nur zu einem Bruchteil als oxidische, nitridische oder karbidische Verbindung aufgebracht werden.

7. Verfahren nach Anspruch 3 bis 6, **dadurch gekennzeichnet,** daß mindestens zwei Komponenten der Dispersionslegierung aus einzelnen, eng nebeneinander angeordneten Verdampfertiegeln aufgedampft werden.

8. Verfahren nach Anspruch 3 bis 6, **dadurch gekennzeichnet,** daß die Dispersionslegierung aus einem Verdampfertiegel (8) aufgedampft wird.

9. Verfahren nach einem der Ansprüche 1 bis 8, **dadurch gekennzeichnet,** daß zwischen Trägerkörper und Gleitschicht eine Diffusionssperrschicht (3) aufgebracht wird.

10. Verfahren nach Anspruch 9, **dadurch gekennzeichnet,** daß die aufgebrachte Diffusionssperrschicht (3) aus Nickel, Nickel/Zinn, Nickel/Kupfer, Nickel/Chrom, Titan oder Titannitrid besteht.

11. Verfahren nach Anspruch 9 oder 10, **dadurch gekennzeichnet,** daß auch die Diffusionssperrschicht (3) durch Elektronenstrahlbedampfung aufgebracht wird und mindestens in einem Winkelbereich von ±70°, bezogen auf den Scheitelbereich (5) des Trägerkörpers (1), eine Abweichung der Schichtdicke von weniger als 15 %, bezogen auf die Maximalschichtdicke, aufweist.

12. Verfahren nach mindestens einem der Ansprüche 1 bis 11, **dadurch gekennzeichnet,** daß die Gleitschicht (4) und/oder Diffusionssperrschicht (3) im Vakuum ohne Reaktivgas aufgedampft wird.

13. Verfahren nach mindestens einem der Ansprüche 1 bis 11, **dadurch gekennzeichnet,** daß die Gleitschicht (4) und/oder Diffusionssperrschicht (3) reaktiv unter Zufuhr eines Reaktivgases und/oder plasmaaktiviert aufgebracht wird.

14. Verfahren nach Anspruch 13, **dadurch gekennzeichnet,** daß als Reaktivgas Sauerstoff, Stickstoff oder Kohlenwasserstoff-Verbindungen oder ein Gemisch dieser Gase verwendet wird.

15. Verfahren nach mindestens einem der Ansprüche 1 bis 14, **dadurch gekennzeichnet,** daß die Diffusionssperrschicht (3) durch Zerstäuben und danach die Gleitschicht (4) in Vakuumfolge durch Elektronenstrahlbedampfung aufgebracht werden.

**Claims**

1. Process for producing concavely curved slide elements, in which a layer system is applied to a carrier body (1), with at least one layer of a metallic dispersion alloy being provided, which at least in an angular range of ± 70°, with reference to the crown region of the carrier body, comprises a deviation in layer thickness of less than 15% with respect to the maximum layer thickness, wherein

- after pretreatment of the concavely curved carrier body (1) at least one layer (4) is applied by electron beam vapour-deposition in such a manner that a distance of from 150 to 350 mm is set between the vaporiser (8) and the plane of the crown region (5) of the slide element ,

- the vaporiser (8) and the carrier body (1) are moved unidimensionally relative to each other at an uneven speed which is greater on entry into and exit from the vapour cloud than over the centre of the vapour beam formed,

- the carrier body (1) is moved at right angles to its axial direction,

- parts of the vapour stream are masked by at least one screen (10), which is fixed relative to the vaporiser (18) and is preferably provided in the centre of the vapour stream, and

- the condensation rate for the deposition of the layer in the crown region of the carrier body (1) is set to at least 80 nm/sec.

2. Process according to claim 1, **characterised in that** at least on the side of the screen (10) facing the vapour stream a temperature is set which is above the melting point of the vaporising material.

3. Process according to one of claims 1 or 2, **characterised in that** the at least one layer is a slide layer of a metallic dispersion alloy.

4. Process according to claim 3, **characterised in that** the dispersion alloy of the vapour-deposited slide layer contains at least one metal from the group comprising aluminium, lead, cadmium, tin, zinc, nickel, copper.

5. Process according to one of claims 3 or 4, **characterised in that** the dispersion alloy of the vapour-deposited slide layer comprises from 15 to 35 wt.% tin and from 0.1 to 3 wt.% copper and aluminium.

6. Process according to one of claims 3 to 5, **characterised in that** the components of the dispersion alloy are applied predominantly in their metallic form and only fractionally as an oxidic, nitridic or carbidic compound.

7. Process according to claim 3 to 6, **characterised in that** at least two components of the dispersion alloy are vapour-deposited from individual vaporiser crucibles provided close together.

8. Process according to claim 3 to 6, **characterised in that** the dispersion alloy is vapour-deposited from one vaporiser crucible (8).

9. Process according to one of claims 1 to 8, **characterised in that** a diffusion barrier layer (3) is applied between the carrier body and the slide layer.

10. Process according to claim 9, **characterised in that** the applied diffusion barrier layer (3) comprises nickel, nickel/tin, nickel/copper, nickel/chromium, titanium or titanium nitride.

11. Process according to claim 9 or 10, **characterised in that** the diffusion barrier layer (3) is also applied by electron beam vapour-deposition and at least in an angular range of $\pm$ 70°, with reference to the crown region (5) of the carrier body (1), comprises a deviation in layer thickness of less than 15% with respect to the maximum layer thickness.

12. Process according to at least one of claims 1 to 11, **characterised in that** the slide layer (4) and/or diffusion barrier layer (3) is vapour-deposited under vacuum without reactive gas.

13. Process according to at least one of claims 1 to 11, **characterised in that** the slide layer (4) and/or diffusion barrier layer (3) is applied reactively by supplying a reactive gas and/or by plasma activation.

14. Process according to claim 13, **characterised in that** oxygen, nitrogen or hydrocarbon compounds or a mixture of these gases is used as the reactive gas.

15. Process according to at least one of claims 1 to 14, **characterised in that** the diffusion barrier layer (3) is applied by sputtering and the slide layer (4) is then applied in a vacuum step by electron beam vapour-deposition.

## Revendications

1. Procédé de fabrication d'éléments de glissement à courbure concave, dans lequel on applique sur un corps support (1) un système à couches, qui présente au moins une couche constituée d'un alliage métallique à dispersion, qui présente, au moins dans une plage angulaire de $\pm$ 70°, par rapport à la zone (5) de flèche du corps support (1), un écart de l'épaisseur de couche de moins de 15% par rapport à l'épaisseur de couche maximale, dans lequel :

- après un pré-traitement du corps support (1) à courbure concave, au moins une couche (4) est appliquée par revêtement par évaporation par bombardement électronique de telle sorte qu'une distance de 150 à 350 mm soit réglée de l'évaporateur (8) jusqu'au plan de la zone (5) de flèche de l'élément de glissement,
- l'évaporateur (8) et le corps support (1) sont déplacés relativement l'un par rapport à l'autre dans une seule dimension à une vitesse non uniforme qui est plus grande à l'entrée dans le nuage de vapeur et à la sortie de celui-ci que au-dessus du centre du cône de vapeur formé,
- le corps support (1) est déplacé à angle droit par rapport à sa direction axiale,
- des parties du flux de vapeur sont supprimées par au moins un diaphragme (10) qui est fixe relativement à l'évaporateur (8) et est disposé de préférence au centre du flux de vapeur, et

- la vitesse de condensation pour le dépôt de la couche dans la zone de flèche du corps support (1) est réglée à au moins 80 nm/s.

2. Procédé selon la revendication 1, caractérisé en ce qu'une température supérieure au point de fusion du matériau d'évaporation est réglée au moins sur le côté du diaphragme (10) faisant face au flux de vapeur.

3. Procédé selon l'une quelconque des revendications 1 ou 2, caractérisé en ce que la au moins une couche est une couche de glissement constituée d'un alliage métallique à dispersion.

4. Procédé selon la revendication 3, caractérisé en ce que l'alliage à dispersion de la couche de glissement appliquée par évaporation contient au moins un métal choisi dans le groupe de l'aluminium, du plomb, du cadmium, de l'étain, du zinc, du nickel et du cuivre.

5. Procédé selon l'une quelconque des revendications 3 ou 4, caractérisé en ce que l'alliage à dispersion de la couche de glissement appliquée par évaporation est constitué de 15% à 35% en poids d'étain et de 0,1% à 3% en poids de cuivre et d'aluminium.

6. Procédé selon l'une quelconque des revendications 3 à 5, caractérisé en ce que les composants de l'alliage à dispersion sont appliqués principalement sous leur forme métallique et seulement en une fraction sous forme de composé oxydé, nitruré ou carburé.

7. Procédé selon les revendications 3 à 6, caractérisé en ce qu'au moins deux composants de l'alliage à dispersion sont appliqués par évaporation à partir de creusets d'évaporation séparés disposés étroitement les uns à côté des autres.

8. Procédé selon les revendications 3 à 6, caractérisé en ce que l'alliage à dispersion est appliqué par évaporation à partir d'un seul creuset d'évaporation (8).

9. Procédé selon l'une quelconque des revendications 1 à 8, caractérisé en ce qu'une couche barrière contre la diffusion (3) est appliquée entre le corps support et la couche de glissement.

10. Procédé selon la revendication 9, caractérisé en ce que la couche barrière contre la diffusion (3) appliquée est constituée de nickel, de nickel/étain, de nickel/cuivre, de nickel/chrome, de titane ou de nitrure de titane.

11. Procédé selon la revendication 9 ou 10, caractérisé en ce que la couche barrière contre la diffusion (3) est également appliquée par revêtement par évaporation par bombardement électronique et présente, au moins dans une plage angulaire de ± 70°, par rapport à la zone (5) de flèche du corps support (1), un écart de l'épaisseur de couche de moins de 15% par rapport à l'épaisseur de couche maximale.

12. Procédé selon au moins l'une quelconque des revendications 1 à 11, caractérisé en ce qu'on applique par évaporation la couche de glissement (4) et/ou la couche barrière contre la diffusion (3) sous vide sans gaz réactif.

13. Procédé selon au moins l'une quelconque des revendications 1 à 11, caractérisé en ce qu'on applique la couche de glissement (4) et/ou la couche barrière contre la diffusion (3) de façon réactive avec amenée d'un gaz réactif et/ou par activation au plasma.

14. Procédé selon la revendication 13, caractérisé en ce qu'on utilise comme gaz réactif de l'oxygène, de l'azote ou des composés hydrocarbonés ou un mélange de ces gaz.

15. Procédé selon au moins l'une quelconque des revendications 1 à 14, caractérisé en ce que la couche barrière contre la diffusion (3) est appliquée par atomisation et ensuite la couche de glissement (4) est appliquée sous vide par revêtement par évaporation par bombardement électronique.

Fig. 1

**Fig. 2**